# EUROPEAN PATENT SPECIFICATION

(11) **EP 2 349 915 B1**
(45) Date of publication and mention of the grant of the patent: **18.07.2012**
(21) Application number: 09753216.2
(22) Date of filing: 10.11.2009
(51) Int. Cl.: B81B 7/00, G01P 1/02, H01L 23/485

(54) **ELECTRICAL CONTACT CONFIGURATION OF MICRO-ELECTROMECHANICAL COMPONENT AND FABRICATION METHOD**
KONFIGURATION EINES ELEKTRISCHEN KONTAKTS EINES MIKRO-ELEKTROMECHANISCHEN BAUELEMENTS UND HERSTELLUNGSVERFAHREN
CONFIGURATION DE CONTACT ÉLECTRIQUE DE COMPOSANT MICRO-ÉLECTROMÉCANIQUE ET PROCÉDÉ DE FABRICATION

(30) Priority: 25.11.2008 FR 0857989; 25.11.2008 US 117803 P
(43) Date of publication of application: 03.08.2011
(73) Proprietor: Tronic's Microsystems, 38920 Crolles (FR)
(72) Inventor: AZOLEY, Philippe, 38100 Grenoble, (FR); GILET, Jean-Michel, F-38600 Fontaine (FR); NICOLAS, Stéphane, F-38240 Meylan (FR)
(74) Representative: Palix, Stéphane
(86) International application number: PCT/IB2009/054988
(87) International publication number: WO 2010/061311

(56) References cited:
- EP-A- 0 660 119
- US-A1- 2005 005 420
- US-A1- 2005 082 653
- US-A1- 2006 038 278

## Description

### Field of the invention

The invention relates to the field of microelectronics, more especially to micro-electromechanical systems (MEMS) technology. More specifically, it aims to provide an improvement in the ways in which MEMS components are electrically connected to other electronic components.

More particularly, it relates to an electrical contact configuration which facilitates various mounting layouts for MEMS components.

### Description of the prior art

Generally speaking, MEMS components are frequently used as sensors and make it possible to convert physical quantities such as pressure, acceleration and force into electrical signals. An MEMS component therefore contains a moving internal portion which is connected to conductive elements which make it possible to transfer the signal thus generated to electrical contacts which can be accessed outside the component.

An MEMS component is generally mounted on or alongside an electronic component which is used to ensure processing of the signal generated by the MEMS component in order to output a correctly formatted signal. In practice, connection between the output terminals of the MEMS component and the input terminals of the processing component can be realized in various ways.

A first technique involves using bump contacts located between these various terminals; this requires geometrical alignment of the contacts of the MEMS component with those of the processing component.

An alternative to this technique, referred to as "bumping", involves using interconnect wires which are soldered, firstly, to the electrical contacts on the surface of the MEMS component and, secondly, to the input terminals of the processing component.

This technique is referred to as wire bonding and allows greater flexibility when positioning the various terminals. However, two soldered joints have to be made on the bond wire for every connection, namely, firstly one on the electrical contacts of the MEMS component and, secondly, one on the electrical contacts of the signal processing component.

These soldering operations are performed using appropriate apparatus which comprises a wire bonding head which moves at right angles to the surface of the contact in order to solder the bond wire onto it.

In the case of MEMS components designed to measure physical quantities in a given direction, the layout and orientation of the MEMS component must be chosen taking into account the conditions under which the device which contains the sensor is used.

For instance, a mono-axial accelerometer measures direction along a predetermined axis as a function of the displacement of the moving portion due to the effect of a force which corresponds to the acceleration to be measured.

Thus, depending on the displacement mode of the moving portion of the MEMS component and using mono-axial sensors, the number of detectors used must be the same as the number of acceleration components that are to be measured.

This means that two acceleration components in the main plane of the device are detected by using two mono-axial MEMS sensors which have their detection axes arranged at right angles in the plane in question.

Measuring acceleration along the third axis, i.e. in a direction perpendicular to the main plane of the device, involves either using an MEMS sensor of a different kind or fitting the same type of MEMS sensor, pivoted through 90°.

Nevertheless, it should be noted that, if connection is obtained by using a wire bonding technique, the MEMS sensor used cannot be strictly identical given the fact that the electrical contacts, having been pivoted, have a configuration which makes them inaccessible to soldering systems.

Document EP 0 660 119 A describes a micro-mechanical acceleration sensor having contacts which allow for wire bonding even if the sensor is in an upright position. The moving portion is made from a silicon substrate and includes a conductive element which is connected to an external electrical contact. The regions in which the contacts are formed are concave and parallel with respect to the sensor's other outer faces.

Another problem encountered with MEMS sensors is their overall dimensions which can be relatively large. In fact, the sensors generally have dimensions in the plane of the substrate which are much larger than their height, measured at right angles to the substrate plane. It is therefore obvious that the detectors occupy a relatively large surface area compared with their height. Document WO 2006/134233 describes a solution to this problem of overall size by proposing that MEMS sensors be mounted on their edges. This solution involves realizing multi-axial MEMS sensors which have a series of contacts made on the edge of the component, i.e. the lateral face which is revealed after separating the various components produced on a single substrate or wafer. The surface area taken up by the sensor on the substrate which accommodates it is therefore reduced.

However, the drawback of this technique is that it involves operations to obtain metallization on the individualized components after they have been separated from the common wafer. It is readily apparent that these various manipulation and metallization operations are complex to implement and increase the cost of such components considerably. Moreover, as stated above, such a sensor can only be mounted on its edge and cannot have any other orientation because its contacts are only accessible for making bond-wire interconnections when the sensor is mounted edgewise.

The problem which the invention therefore aims to solve is that of producing MEMS components which have the following features: they can be used in various orientations and, especially after pivoting through 90°, they are compatible with conventional wire bonding techniques and can be produced collectively, i.e. several MEMS components can be produced on a single wafer before being separated.

### Summary of the invention

The invention therefore relates to a micro-electromechanical component produced from a single wafer of a semiconductor material. This component comprises, conventionally, an internal moving portion which includes conductive elements and contacts on its outer surface. These contacts are electrically connected to conductive elements and are capable of accommodating soldered interconnect wires which are themselves designed to be connected to electrical contacts provided on a device which accommodates the component.

In accordance with the invention, this component is characterized in that the electrical contacts are arranged in an area which extends between the upper face of the component and a lateral face. These contacts have a concave shape and have two regions which are substantially perpendicular to each other and parallel to the upper face and the lateral face of the component respectively, and in that both regions are capable of accommodating soldered interconnect wires.

In other words, the invention involves producing contacts which have a complex shape and a geometry such that they have a surface which is parallel to that of the component intended to accommodate the MEMS component, regardless whether the latter is arranged conventionally (flat) or pivoted through 90°. In other words, the electrical contacts of the MEMS component always have a portion which is parallel to the contacts of the processing component so that bond-wire soldering operations can be performed using conventional equipment.

In practice, the lateral face which is opposite that which comprises the electrical contacts is advantageously flat so that it can be positioned stably on the device, thereby accentuating the distinctive component.

In practice, the MEMS component can be produced by assembling various layers made up of separate wafers. In this case, the internal moving portion is produced on a first layer and can be covered by a second layer which forms a cap, in which case the electrical contacts may advantageously be located on the cap in question so that they are accessible on the upper face of the component.

In this case, the distinctive electrical contacts are produced on a first wafer which is different to that from which the moving portions which form the core of the sensor are made.

In practice, the two perpendicular regions of the electrical contact can be linked to each other by a flat zone which slopes relative to the upper face of the component at an angle which is neither zero nor straight.

Advantageously, the two perpendicular regions of the electrical contact have surfaces of the same order of magnitude, i.e. surface areas having a ratio which is preferably less than 5. This makes it possible to reap the benefits of a surface area which is sufficiently large to ensure soldering using conventional means while ensuring that the electrical contact does not occupy an excessively large surface area on the component.

Thus, the invention also relates to a method for fabricating such a component from a wafer of a semiconductor material. In this case, the method according to the invention is characterized in that it involves the following steps:
■ On each future component which is present on the wafer, forming at least one recess at the level of a straight edge which links the upper face and the lateral face of the future component, this recess comprising a first region which is substantially parallel to the lateral surface and a second region which is substantially parallel to the upper surface;
■ Then, depositing a metal layer which continuously covers both these regions, this metal layer being electrically connected to the conductive elements inside the component;
■ Finally, separating the various components formed on the same wafer in order to individualize them without the need for subsequent operations to create electrical contacts.

In practice, this recess can advantageously be produced by a succession of the following steps: a wet etching process intended to form the junction surface between the first and second regions of the contacts designed to accommodate the interconnect wires, then a dry etching process intended to form the second region which is parallel to the lateral face of the component.

### Brief description of the drawings

The way in which the invention is implemented and its resulting advantages will be more readily understood from the following description of its embodiments, reference being made to the accompanying drawings in which:
Figures 1 to 7 are cross-sectional views of an MEMS component during the course of fabrication as the various steps in the method are completed.
Figures 8 and 9 are cross-sectional views of the component produced in the previous Figures mounted on an additional component in two different orientations.
Figures 10 and 11 are cross-sectional views of the component produced in the previous Figures connected to an additional component and mounted on a support substrate in two different orientations.

### Description of the preferred embodiment

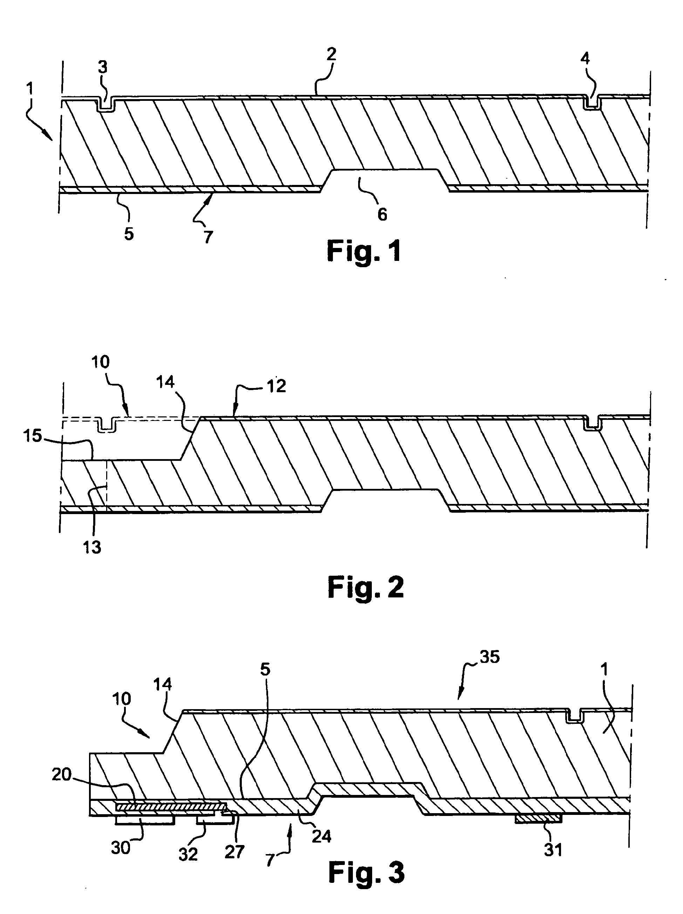

Figures 1 to 7 illustrate a specific method for implementing the invention but only show the main steps that relate to the invention. Necessary but conventional steps which have no direct bearing on the invention are not described in detail.

Similarly, the dimensions shown, especially thicknesses, are given for information only and may differ from the real dimensions insofar as they were chosen in order to make the invention more readily comprehensible.

Figure 1 shows a silicon wafer **1** intended to form the cap of a future MEMS component. For this purpose, the wafer comprises, on its upper face, oxidation layer **2** and marks **3** and **4** which are conventionally arranged to allow alignment and ultimate dicing of the wafer in order to separate the various components produced thereon. This lid **1** comprises, on its lower face, passivation layer **5** and recess **6** which is made after opening passivation layer **5** and an etching process used to define the cavity which is located vertically above the future moving areas of the MEMS component.

In a second step shown in Figure 2, a partial recess **10** is formed on upper face **12.** The term "upper face" is taken to mean a face which is parallel to the main plane of wafer **1** and will be located on the outside of the future component.

This recess **10** is produced conventionally by wet etching which makes it possible to define sloping flank **14** and a flat **15** which forms the bottom of recess **10** and is parallel to upper face **12.** This flat **15** extends internally into the volume of the future component and future lateral face **13** which is shown in a dashed line vertically below dicing mark **3** shown in Figure 1.

A metal layer intended to form tracks **20** and **21** is deposited in a subsequent step which is shown in Figure 3. These tracks **20, 21** are deposited on passivation layer **5** on the lower face of the wafer.

Layer **20** is deposited vertically below flank **14** of recess **10**. Lower face **7** is then covered in a layer of a dielectric material which is intended to insulate electrode **20**. This dielectric layer **24** which covers the entire lower face of the wafer is then etched in order to produce opening **27** which provides access to electrode **20**. A step to deposit sealing metal **30** is then performed; this seal makes it possible to perform assembly with the wafer in which the moving parts of the MEMS component will have been produced. The layers which form the sealing material are then arranged so as to form a barrier around recess **6**. Portion **30** is located vertically below the lateral face of the component. Deposited metal **32** is electrically connected to electrode **20** via a portion which extends into opening **27**.

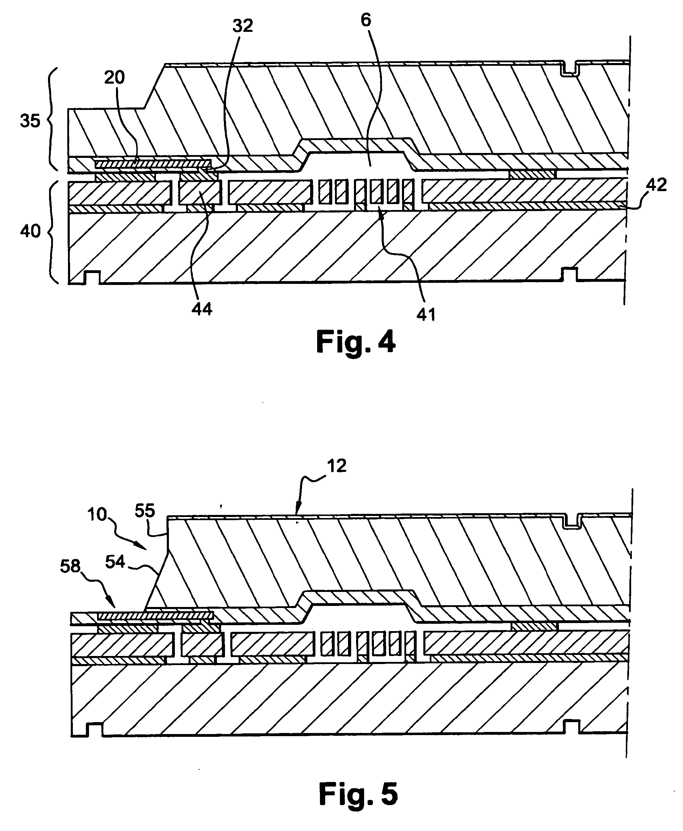

Then, in a subsequent step shown in Figure 4, lid **35** which is thus produced is assembled with a second wafer **40** on which moving portions **41**, which are located vertically below recess **6**, have been produced. Wafer **40** includes intermediate insulating layer **42** which makes it possible to define various electrical connections, especially conductive portions **44** which will make it possible to pick off the electrical signal generated at the level of moving parts **41**. Thus, conductive portion **44** is in contact with electrode **20** via bump contact **32**.

After assembling the two wafers as shown in Figure 5, a step is then performed to enlarge recess **10**. This enlargement is achieved by dry etching which makes it possible to eliminate the portion of the substrate which is vertically above the contact of electrode **20** so as to expose the latter.

Lateral flank **14** is thus extended downwards towards sloping flank **54**. Dry etching is used to produce flank **55** which is perpendicular to upper face **12** of the component.

This flank **55** is intended to accommodate an area of the future distinctive contact and must therefore be sufficiently high to allow soldering of the bond wires. Nevertheless, it must not be excessively high because, as explained below, it will have to receive metal deposited on a surface which is therefore perpendicular to the upper face of the wafer.

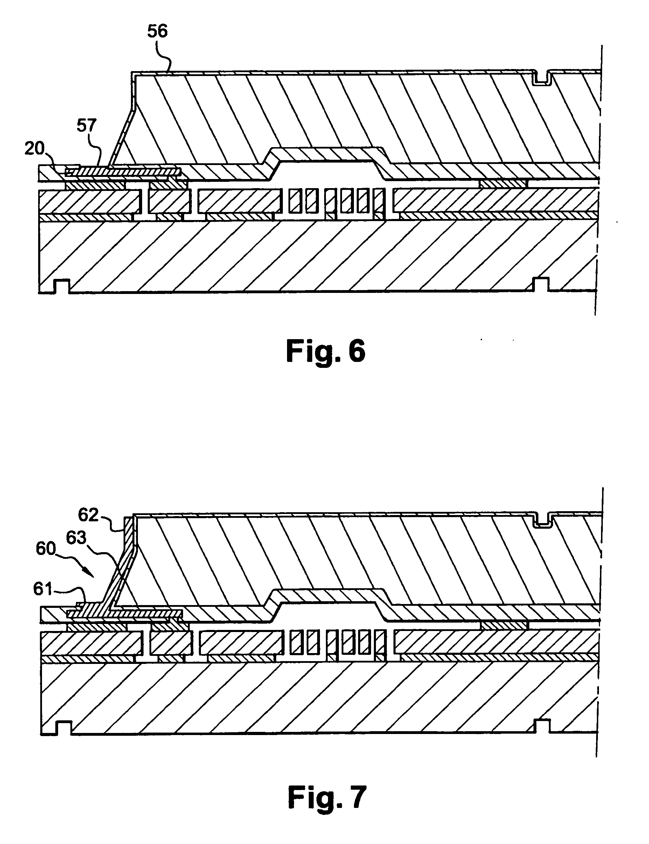

In a subsequent step shown in Figure 6, a layer of a dielectric material is deposited over the entire upper face of the component. This layer **56** is etched in the area of opening **57** so as to obtain access to electrode **20**.

Then, in a subsequent step shown in Figure 7, a metal layer is deposited on recess **10** so as to cover the vertical flank **55**, sloping flank **54** and bottom **58** of the recess. This creates the distinctive contact **60** which has a first region **62** which is parallel to upper face **12** of the wafer and second region **61** which is parallel to the future lateral face of the component. These two regions are linked by portion **63** which covers sloping flank **54**.

This metallization step can be performed in various ways, ensuring that the deposited metal is as compliant as possible, especially in the vicinity of vertical flank **55**.

The metal can be deposited using a Physical Vapor Deposition (PVD) technique which may or may not be combined with using a fixture to orient the wafer, making it possible to deposit metal on vertical flank **55**.

It is thus possible to deposit metal over the entire exposed surface area of the component on which a mask will previously have been produced by depositing and structuring a film which has openings in those areas where the deposited metal is to be preserved. It is also possible to deposit the metal through a shadow mask with, however, the risk of greater variation in the thickness of the deposited metal.

In a subsequent step which is not shown, the various components are separated from each other by cutting the wafer in accordance with initial marks **3**, **4**.

It goes without saying that the method described above is merely illustrative and that other methods involving classic elementary steps can be implemented in order to achieve a structure which is similar and embodies the essential aspects of the invention.

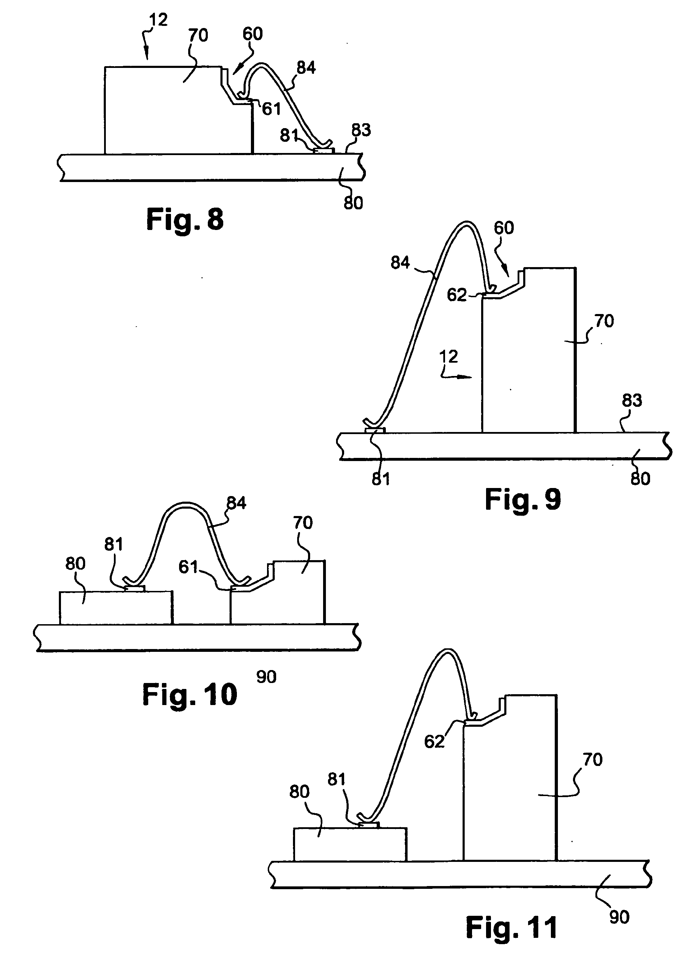

After finalizing the component, it can be used in the two types of setup shown in Figures 8 and 9. Thus, as shown in Figure 8, MEMS component **70** can be placed on another component, especially a processing component **80** in which the signal, resulting from the mechanical phenomena which occur inside MEMS component **70**, is shaped and formatted. In this case, MEMS component **70** rests substantially flat on its inner face **86** on component **80**, component **80** has contacts **81** which allow connection to MEMS component **70** at the level of contact **60** and, more precisely, portion **61** which is parallel to upper face **12** of component **70**.

Conversely and as shown in Figure 9, the same component **70** can be mounted after pivoting it through 90° so that its upper face **12** is perpendicular to the upper face **83** of component **81**. MEMS component **70** then rests on its lateral face **87** on component **80**. Interconnect wire **84** is connected firstly to contact **81** of component **80** and secondly to portion **62** of distinctive contact **60**.

Similarly, as shown in Figure 10, MEMS component **70** can be mounted on its lower face on support substrate **90** in the vicinity of processing component **80**. It is electrically connected to it by interconnect wire **84** which is soldered firstly to contact **81** of component **80** and secondly to contact **60** and, more precisely, to portion **61** which is parallel to the upper face of MEMS component **70**. Conversely and as shown in Figure 11, the same MEMS component **70** can be mounted on support substrate **90** on its lateral face or side edge. In this case, electrical connection with the processing component is obtained via portion **62** of contact **60** which is parallel to the lateral face.

The above description makes it apparent that the invention has the major advantage of allowing vertical and/or horizontal mounting of an identical MEMS component in a manner which is compatible with wire bonding techniques. Thus, a single identical component produced using a single fabrication chain can be used in two different mounting orientations.

### Industrial applications

One preferred application of the invention is to produce sensors designed to measure vector quantities, especially inertia quantities. This includes linear or angular acceleration sensors such as accelerometers and rate gyros. The invention is also suitable for producing sensors where orientation or positioning in the sensitive area is a requirement. Examples include pressure sensors which incorporate a deformable membrane; their positioning, especially their communication with the space in which the pressure is to be measured, can thus be optimized.

## Claims

1. Micro-electromechanical component (70) produced from a semiconductor substrate, comprising an internal moving portion (41) which includes conductive elements (44) and contacts (60) on its outer surface, said contacts (60) being electrically connected to said conductive elements (44), said electrical contacts (60) being capable of accommodating bond-wire interconnections (84) which are themselves designed to be connected to electrical contacts (81) provided on device (80) which accommodates said component (70), ***characterized* in that** electrical contacts (60) are arranged in an area which extends between upper face (12) and lateral face (13) of the component, said contacts (60) having a concave shape and having two regions capable of accommodating bond-wire interconnections, said regions (61, 62) being substantially perpendicular to each other and parallel to said upper face (12) and said lateral face (13) respectively.

2. Component as claimed in claim 1, ***characterized* in that** the two perpendicular regions (61, 62) of the electrical contact are linked by a flat zone (63) which slopes relative to upper face (12).

3. Component as claimed in claim 1, ***characterized* in that** it comprises a portion (35) forming a cap which covers the internal moving portion (41), electrical contacts (60) being located on said cap (35).

4. Component as claimed in claim 1, ***characterized* in that** the two regions (61, 62) have surface areas having a ratio of less than 5.

5. Component as claimed in claim 1, ***characterized* in that** the lateral face (87) which is opposite to the face (13) which accommodates electrical contacts (60) is substantially flat.

6. Method of fabricating micro-electromechanical components from a wafer of a semiconductor material, each component (70) comprising an internal moving portion (41) which includes conductive elements (44), and contacts (60) on its outer face, said contacts (60) being electrically connected to said conductive elements (44), the contacts being designed to accommodate bond-wire interconnections (84) allowing connection to electrical contacts (81) of other components (80), ***characterized* in that** it comprises the following steps:
- On each future component on said wafer, forming at least one recess (10) at the level of a straight edge linking upper face (12) and lateral face (13) of the future component, said recess (10) comprising a first region (61) which is substantially parallel to lateral surface (13) and a second region (62) which is substantially parallel to upper surface (12), both regions (61, 62) being suitable for accommodating bond-wire interconnections ;
- Depositing a metal layer which continuously covers both regions (61, 62) of each recess, said recess being electrically connected to the conductive elements;
- Separating the various components (70) formed on the same wafer.

7. Method as claimed in claim 6, ***characterized* in that** said recess (10) is produced by succession of the following steps: a wet etching process intended to form the junction surface (54) between the first region and the second region (55) and a dry etching process intended to form the second region which is parallel to lateral face (13).

## Patentansprüche

1. Mikroelektromechanisches Bauelement (70), das aus einem Halbleitersubstrat hergestellt ist, umfassend
einen inneren, beweglichen Teil (41), der auf seiner Außenfläche leitfähige Elemente (44) und Kontakte (60) enthält, wobei die Kontakte (60) mit den leitfähigen Elementen (44) elektrisch verbunden sind; die elektrischen Kontakte (60) geeignet sind, um Bonddrahtverbindungsleitungen (84) unterzubringen, die selbst so gestaltet sind, um mit elektrischen Kontakten (81) verbunden zu werden, die auf einer Vorrichtung (80) vorgesehen sind, die dieses Bauelement (70) aufnimmt,
**dadurch gekennzeichnet, dass**
elektrische Kontakte (60) in einer Fläche angeordnet sind, die sich zwischen einer oberen Fläche (12) und einer Seitenfläche (13) des Bauelements erstreckt, die Kontakte (60) eine nach innen gewölbte Form besitzen und zwei Bereiche aufweisen, die geeignet sind, um Bonddrahtverbindungsleitungen unterzubringen, die Bereiche (61, 62) sich im Wesentlichen senkrecht zueinander und parallel zu der oberen Fläche (12) bzw. der Seitenfläche (13) befinden.

2. Bauelement nach Anspruch 1, **dadurch gekennzeichnet, dass**
die zwei senkrechten Bereiche (61, 62) des elektrischen Kontakts durch einen flachen Bereich (63), der bezüglich der oberen Fläche (12) schräg abfällt, verbunden sind.

3. Bauelement nach Anspruch 1, **dadurch gekennzeichnet, dass**
es einen Teil (35) aufweist, der einen Aufsatz bildet, der den inneren, beweglichen Teil (41) bedeckt, wobei die elektrischen Kontakte (60) sich auf dem Aufsatz (35) befinden.

4. Bauelement nach Anspruch 1, **dadurch gekennzeichnet, dass**
die zwei Bereiche (61, 62) Flächenbereiche mit einem Verhältnis von weniger als 5 aufweisen.

5. Bauelement nach Anspruch 1, **dadurch gekennzeichnet, dass** die Seitenfläche (87) gegenüber der Fläche (13), die elektrische Kontakte (60) aufnimmt, im Wesentlichen flach ist.

6. Verfahren zur Herstellung von mikroelektromechanischen Bauelementen aus einem Wafer eines Halbleiterwerkstoffes, wobei jedes Bauelement (70) einen inneren, beweglichen Teil (41) aufweist, der auf seiner Außenfläche leitfähige Elemente (44) und Kontakte (60) enthält, wobei die Kontakte (60) mit den leitfähigen Elementen (44) elektrisch verbunden und so gestaltet sind, um Bonddrahtverbindungsleitungen (84) unterzubringen, die eine Verbindung mit elektrischen Kontakten (81) anderer Bauelemente (80) ermöglichen,
**dadurch gekennzeichnet, dass** es die folgenden Schritte umfasst:
- auf jedem künftigen Bauelement auf dem Wafer, Formen von zumindest einer Ausnehmung (10) auf dem Niveau einer die obere Fläche (12) und Seitenfläche (13) des künftigen Bauelements verbindenden geraden Kante, wobei die Ausnehmung (10) einen ersten Bereich (61), der im Wesentlichen parallel zu der Seitenfläche (13) ist, und einen zweiten Bereich (62), der im Wesentlichen parallel zu der oberen Fläche (12) ist, aufweist, und beide Bereiche (61, 62) zur Unterbringung von Bonddrahtverbindungsleitungen geeignet sind;
- Abscheiden einer Metallschicht, die beide Bereiche (61, 62) von jeder Ausnehmung ständig bedeckt, wobei die Ausnehmung mit den leitfähigen Elementen elektrisch verbunden ist;
- Trennen der verschiedenen Bauelemente (70), die auf dem gleichen Wafer ausgebildet sind.

7. Verfahren nach Anspruch 6, **dadurch gekennzeichnet, dass**
die Ausnehmung (10) durch Aufeinanderfolge der folgenden Schritte erzeugt wird:
nasschemischer Ätzvorgang, der auf einer Übergangsfläche (54) zwischen dem ersten Bereich und dem zweiten Bereich (55) zum Formen bestimmt ist, und
Trockenätzvorgang, der zum Formen des zweiten Bereichs, der sich parallel zu der Seitenfläche (13) befindet, bestimmt ist.

## Revendications

1. Composant microélectromécanique (70) réalisé à partir d'un substrat semi-conducteur, comprenant une portion interne mobile (41) incluant des éléments conducteurs (44) et des contacts présents (60) sur sa surface extérieure, lesdits contacts (60) étant connectés électriquement auxdits éléments conducteurs (44), lesdits contacts électriques (60) étant aptes à recevoir par soudure des fils de connexion (84) eux-mêmes destinés à être reliés à des contacts électriques (81) agencés sur un dispositif (80) recevant ledit composant (70), ***caractérisé* en ce que** les contacts électriques (60) sont disposés dans une zone s'étendant entre la face supérieure (12) du composant et une face latérale (13) du composant, lesdits contacts (60) présentant une forme concave, et possédant deux régions aptes à recevoir par soudure les fils de connexion, lesdites régions (61, 62) sensiblement perpendiculaires l'une à l'autre, et parallèles respectivement à ladite face supérieure (12) et à ladite face latérale (13).

2. Composant selon la revendication 1, ***caractérisé* en ce que** les deux régions perpendiculaires (61, 62) du contact électrique sont reliées par une fraction plane (63) inclinée par rapport à la face supérieure (12).

3. Composant selon la revendication 1, ***caractérisé* en ce qu'**il comporte une portion (35) formant capot, recouvrant la portion interne mobile (41), les contacts électriques (60) étant agencés sur ledit capot (35).

4. Composant selon la revendication 1, ***caractérisé* en ce que** les deux régions (61, 62) présentent des superficies dont le rapport est inférieur à 5.

5. Composant selon la revendication 1, ***caractérisé* en ce que** la face latérale (87) opposée à celle (13) recevant les contacts électriques (60) est sensiblement plane.

6. Procédé de fabrication de composants microélectromécaniques, à partir d'une galette d'un matériau semi-conducteur, chaque composant (70) comprenant une portion interne mobile (41) incluant des éléments conducteurs (44), et des contacts présents (60) sur sa surface extérieure, lesdits contacts (60) étant électriquement connectés auxdits éléments conducteurs (44), les contacts étant destinés à recevoir par soudure des fils conducteurs (84) en vue de la connexion à des contacts électriques (81) d'autres composants (80), ***caractérisé* en ce qu'**il comprend les étapes suivantes consistant à :
■ au niveau de chaque futur composant présent sur ladite galette, former au moins un évidement (10) au niveau d'une arête reliant la face supérieure (12) et une face latérale (13) du futur composant, ledit évidement (10) comportant une première région (61) sensiblement parallèle à la surface latérale (13) et une seconde région (62) sensiblement parallèle à la surface supérieure (12), les deux régions (61, 62) étant aptes à recevoir par soudure des fils de connexion ;
■ déposer une couche métallique recouvrant continûment les deux régions (61,62) de chaque évidement, ladite couche étant électriquement reliée aux éléments conducteurs ;
■ séparer les différents composants (70) formés sur la même galette.

7. Procédé selon la revendication 6, ***caractérisé* en ce que** ledit évidement (10) est réalisé par la succession d'une étape de gravure humide destinée à former la surface de jonction (54) entre la première et la deuxième région (55), et une étape de gravure sèche destinée à former la seconde région parallèle à la face latérale (13).
